# DEMANDE DE BREVET EUROPEEN

(11) **EP 4 687 388 A1**
(43) Date de publication de la demande: **04.02.2026**
(21) Numéro de dépôt: 25186516.8
(22) Date de dépôt: 01.07.2025
(51) Int. Cl.: H05K 7/20

(54) **SYSTÈME ÉLECTRONIQUE COMPRENANT UN MOYEN DE GESTION DES DISTANCES DE FUITE ET DE DÉGAGEMENT**

(30) Priorité: 01.08.2024 FR 2408544
(71) Demandeur: Valeo eAutomotive Germany GmbH, 91056 Erlangen (DE)
(72) Inventeur: ZOJCESKI, Zdravko, 95892 Cergy Pontoise (FR); POUILLY, Aurélien, 95892 Cergy Pontoise (FR); HUBERT, Daniel, 95892 Cergy Pontoise (FR)
(74) Mandataire: Valeo Powertrain Systems

(57) **Abrégé**

L'invention concerne un système électronique (1) comprenant un module électronique (6) et un dispositif de refroidissement (10) comprenant un conduit de circulation (32) de fluide délimité par une paroi d'échange thermique (12) contre laquelle est rapporté le module (6), la paroi (12) étant dotée d'une base (14) et d'une excroissance (16) connectée thermiquement au module (6) et permettant de le positionner à distance de la base (14) dans une direction verticale (V), le système électronique étant muni d'un moyen de gestion (24) des distances de fuites et de dégagement entre au moins une broche de connexion (22) du module et la paroi (12), le moyen de gestion comprenant un ensemble d'isolation composé d'au moins deux moyens isolants de rigidité différente parmi lesquels un premier moyen isolant (26) est comprimé entre la base (14) et le module (6), et un deuxième moyen isolant (28) s'étend perpendiculairement à la direction verticale (V).

## Description

La présente invention se rapporte au domaine des systèmes électroniques implantés au sein de véhicule électrique.

Dans les applications actuelles, des systèmes électroniques comportant des modules de puissance sont prévus afin de gérer la tension électrique et par exemple gérer la transformation d'un courant continu en courant alternatif dans les dispositifs de charge embarqués pour les véhicules automobiles.

Ces dispositifs de charges embarquées comprennent ainsi une pluralité de systèmes électroniques qui peuvent respectivement comporter un module électronique muni d'au moins une broche de connexion électrique destinée à être connectée électriquement avec une carte de circuit imprimées, un onduleur ou un convertisseur DC/DC.

Ces dispositifs de charge embarqués comprennent un ou plusieurs modules de puissance comportant chacun, dans un boîtier de protection qui leur est propre, un support et des puces électroniques fixées sur le support et logées au sein du boîtier de protection. Le raccordement électrique de ces puces, via le support, se fait par l'intermédiaire de broches de connexion électrique destinées à être connectées électriquement avec une carte de circuit imprimées, les broches de connexion électrique traversant à cet effet le boîtier de protection. Lesdites broches n'étant pas isolées électriquement pour ce qui est de la portion en saillie du boîtier de protection, il est nécessaire de prévoir des distances de chemin de fuite (aussi appelé "creepage" dans la littérature anglophone) et des distances de dégagement (aussi appelé "clearance" dans la littérature anglophone) entre chacune des broches et les composants conducteurs disposés au voisinage du module de puissance, des distances trop faibles pouvant entraîner aux mieux des interférences électriques entre ces éléments et produire des phénomènes électriques indésirables entraînant un dysfonctionnement dudit module de puissance et au pire provoquer des défauts d'isolement pouvant par exemple entraîner un danger d'incendie ou un danger d'électrocution.

Afin de dissiper la chaleur générée par la puissance du module électronique, les systèmes électroniques comprennent un dispositif de refroidissement qui peut notamment comporter une paroi d'échange de chaleur fabriquée en un matériau thermiquement conducteur. Typiquement ce matériau est également électriquement conducteur, de sorte qu'il est nécessaire tel qu'évoqué ci-dessus de prévoir des distances de fuite et des distances de dégagement entre les broches et les parois conductrices du dispositif de refroidissement.

En outre, il convient d'assurer les distances d'isolement électrique, puisque les parois du dispositif de refroidissement peuvent se recouvrir d'une pellicule d'eau due à un phénomène de condensation. Ainsi, lorsque les parois sont situées au-dessus du module de puissance, l'eau peut alors s'écouler sur celui-ci sous l'effet de la gravité et entraîner divers problèmes.

La distance de dégagement ("clearance") correspond à la plus courte distance dans l'air séparant ces composants, tandis que la distance de fuite ("creepage") correspond à la plus courte distance mesurée le long d'une surface isolante agencée entre lesdits composants électriques et/ou électroniques. Ces distances sont notamment régies par des normes industrielles telles que la norme NF EN IEC 60664-1.

Ces normes régissant ces distances définissent une distance qui dépend notamment de la tension de fonctionnement des composants électriques et/ou électroniques. Plus la tension de ces composants est élevée, plus les distances de fuite et de dégagement requises sont grandes. Ces normes posent des défis car, de nos jours et notamment dans les applications pour des véhicules électriques, les modules de puissance doivent être de plus en plus compacts et sont destinés à traiter des tensions de plus en plus élevées. Cela peut entraîner des problèmes d'encombrement mécanique, car choisir d'appliquer de grande distance de fuite et de dégagement peut nécessiter un écartement excessif entre deux composants électriquement conducteurs, ce qui limite la miniaturisation.

L'objectif de l'invention décrite dans le présent document est donc de pallier les désavantages de l'art antérieur en proposant un système électronique comprenant un carter logeant un module électronique et un dispositif de refroidissement. Le système électronique est muni d'un moyen de gestion des distances de fuites et de dégagement composé d'au moins deux moyens isolants de rigidité différente et permettant ainsi d'utiliser des tensions élevées tout en respectant les normes définissant l'isolement des composants électriques, dans un encombrement réduit du système électronique.

La présente invention a ainsi pour principal objet un système électronique comprenant un carter ainsi qu'un module électronique et un dispositif de refroidissement dudit module électronique qui sont logés dans ledit carter, le module électronique comportant des puces électroniques logées dans un boîtier de protection et des broches de connexion raccordées auxdites puces et traversant le boîtier de protection, le dispositif de refroidissement comprenant un conduit de circulation de fluide délimité au moins par une paroi d'échange thermique contre laquelle est rapporté le module électronique, la paroi d'échange thermique étant dotée d'une base et d'une excroissance connectée thermiquement au module électronique via une matière d'interface thermique et permettant de positionner le module électronique à distance de la base dans une direction verticale, le système électronique étant muni d'un moyen de gestion des distances de fuites et de dégagement entre au moins une broche de connexion du module électronique et la paroi d'échange thermique, caractérisé en ce que le moyen de gestion comprend un ensemble d'isolation composé d'au moins deux moyens isolants de rigidité différente parmi lesquels un premier moyen isolant est comprimé entre la base de la paroi d'échange thermique et le module électronique, et un deuxième moyen isolant s'étend perpendiculairement à la direction verticale.

Le système électronique est notamment conçu pour être utilisé dans un dispositif de charge embarqué pour véhicule électrique, qui a pour fonction de convertir le courant alternatif d'une borne de charge individuelle en un courant continu utilisable pour l'entrainement du véhicule. A cet effet, le système électronique comporte une pluralité de composants électroniques logés au sein d'un carter, parmi lesquels au moins un module électronique dont le fonctionnement génère beaucoup de chaleur qu'il convient d'évacuer en dehors de ce carter.

Le carter du système électronique sert de moyen de protection à chacun de ces composants et présente des moyens de fixation notamment du dispositif de refroidissement.

Le fluide circulant au sein du conduit de circulation est, quant à lui, un fluide caloporteur, qui a donc la capacité d'échanger des calories avec son environnement. De cette manière, on comprend qu'un échange de calories peut avoir lieu entre le module électronique et le fluide circulant dans le conduit de circulation, par l'intermédiaire de la paroi d'échange thermique.

Pour cela, on comprend que la paroi d'échange thermique, et notamment dans la zone contre laquelle est rapporté le module électronique, c'est-à-dire l'excroissance, doit être fabriquée en un matériau thermiquement conducteur, également conducteur électriquement. En outre, l'au moins une broche est fabriquée en un matériau électriquement conducteur afin d'être connectée électriquement à des éléments extérieurs au module électronique, par exemple une carte de circuit imprimé. Dans ce contexte, il peut y avoir des problèmes d'interférences dus à des distances de fuite et de dégagement trop courtes entre l'au moins une broche et la paroi d'échange thermique, d'où l'utilité du moyen de gestion des distances de fuite et de dégagement afin de d'imposer une dérivation des distances de fuite et de dégagement.

Le module électronique présente une face inférieure du boîtier qui est au contact directement ou indirectement avec la paroi d'échange thermique dans une zone de fixation qui est ici l'excroissance, le cas échéant avec une matière d'interface thermique entre les puces électroniques et l'extérieur du boîtier afin d'augmenter les performances d'échange thermique.

Le module électronique étant disposé à distance de la base dans la direction verticale grâce à l'excroissance, les puces électroniques et les broches de connexion de ce module électronique sont agencées à distance de la paroi d'échange thermique lorsque la face inférieure du boîtier est au contact de l'excroissance.

Plus particulièrement, les broches du module électronique sont disposées à distance de la base de la paroi d'échange thermique dans la direction verticale, la direction verticale étant ici une direction s'étendant entre ledit module et ladite base de la paroi d'échange thermique, perpendiculairement à ces deux objets. On comprend ainsi qu'en l'absence de moyen de gestion, un espacement vide est formé entre les broches du module électronique et la base de la paroi d'échange thermique. La distance de dégagement irait alors de la broche à la base de la paroi d'échange thermique en passant dans l'air par l'espacement vide, et la distance de fuite irait de la broche à **l'excroissance** de la paroi d'échange thermique, en longeant une surface isolante du module électronique. Dans les deux cas, en l'absence du moyen de gestion, ces distances seraient trop courtes. En outre, sous l'action de la gravité, une fine pellicule d'eau se déposant sur les parois du dispositif de refroidissement par condensation est susceptible de s'écouler sur le module de puissance et d'endommager le système électronique.

Le premier moyen d'isolation, en étant comprimé entre la base de la paroi d'échange thermique et le module électronique, forme une barrière d'isolation autour de l'excroissance de cette paroi. Cela a notamment pour effet de rallonger la distance de fuite, puisque celle-ci passe, depuis une des broches, le long de la surface isolante du module électronique, puis le long du premier isolant sans pouvoir atteindre l'excroissance. Le premier moyen d'isolation empêche également l'accumulation d'eau issue de la condensation sous le module de puissance, ce qui favorise la fiabilité du matériel d'interface thermique (TIM : Thermal Interface Material dans la littérature anglaise) en évitant l'immersion dudit matériel dans l'eau, pour laquelle il n'est pas conçu.

Il convient de noter que le premier moyen isolant peut être comprimé directement entre la base et le module, ou indirectement par l'intermédiaire d'un autre élément, par exemple le deuxième moyen isolant. Ce premier moyen isolant est dit comprimé dans la mesure où il présente, à titre d'exemple, une rigidité comprise entre 1 et 10 Mpa environ.

Le deuxième moyen isolant, en s'étendant perpendiculairement à la direction verticale, s'étend dans la même direction que la base de manière à recouvrir au moins en partie cette dernière. Cela a notamment pour effet de rallonger la distance de fuite précédemment évoquée, puisque celle-ci doit alors longer, à la suite du premier moyen isolant, le deuxième moyen isolant, en partant à l'opposé de l'excroissance. Cela a également pour effet de rallonger la distance de dégagement, puisque celle-ci doit contourner la matière isolante du deuxième moyen isolant pour s'étendre dans l'air de la broche jusqu'à atteindre la base de la paroi d'échange thermique dans une zone de la base non recouverte par le deuxième moyen isolant.

En même temps, ce deuxième moyen d'isolation électrique par effet d'isolation thermique des parois froides du dispositif de refroidissement réduit le phénomène de condensation lors de conditions météorologiques favorisant cette condensation.

Selon une caractéristique optionnelle de l'invention, le deuxième moyen isolant est en contact avec le premier moyen isolant et avec la base de la paroi d'échange thermique.

Le contact entre le premier moyen isolant et le deuxième moyen isolant permet d'assurer une continuité de l'isolation, de sorte qu'un courant électrique longeant la surface du premier moyen isolant doit continuer le long de la surface du deuxième moyen isolant, rallongeant d'autant la distance de fuite.

On comprend en effet que la distance de fuite est rallongée puisqu'après avoir longé les surfaces isolantes du module et du premier moyen isolant, elle continue le long du deuxième moyen isolant jusqu'à atteindre la base de la paroi d'échange thermique dans la zone non recouverte par le deuxième moyen isolant.

Selon une caractéristique optionnelle de l'invention, le premier moyen isolant est interposé entre le deuxième moyen isolant et le module électronique.

Il convient alors de comprendre que le premier moyen isolant est comprimé entre le module électronique et la base de la paroi d'échange thermique par l'intermédiaire du deuxième moyen isolant. De cette manière, le contact entre le premier moyen isolant et le deuxième moyen isolant est étroit puisque le premier moyen isolant est comprimé par le deuxième moyen isolant, ce qui permet alors d'assurer la continuité de l'isolation.

Selon une caractéristique optionnelle de l'invention, le premier moyen isolant et le deuxième moyen isolant sont fixés l'un à l'autre.

Le premier moyen isolant peut, par exemple, être fixé au deuxième moyen isolant par adhérence. Dans ce cas, le premier moyen isolant peut-être une colle appliquée au contact du deuxième moyen isolant après son positionnement.

Alternativement, le premier moyen isolant peut également être fixé au deuxième moyen isolant à l'aide de moyens de fixation.

Selon une caractéristique optionnelle de l'invention, le deuxième moyen isolant est une plaque, une feuille ou un film. Le deuxième moyen isolant peut-être d'épaisseur constante, ou bien présenter une épaisseur variable.

Le deuxième moyen isolant est de préférence fabriqué à partir de polymères fluorés tels que le polytétrafluoroéthylène (PTFE), le polypropylène (PP), le fluoroalkylate (PA), le perfluoroalkylate (PFA), l'éthylène-propylène fluoré (FEP) et le tétrafluoroéthylène (TFE). L'utilisation de ces matériaux garantit de bonnes performances en termes de tenue de cheminement, également connue sous le nom de "Comparative Tracking Index" (CTI) dans la littérature anglophone. Il est également possible d'utiliser d'autres types de matériaux, tels que les polymères en polyester (PET), le polystyrène (PS), le polynaphtalate d'éthylène (PEN), le polypropylène (PPS), le polyimide (PI) et des matériaux similaires. Alternativement, une ou plusieurs couches de polymères organiques, par exemple des résines époxy ou silicones, déposées en tant que de peinture isolante peuvent être employées comme deuxième moyen isolant. En outre, une ou plusieurs couches de matières organiques, hybrides ou inorganiques peuvent servir de deuxième moyen isolant en étant appliqués par des procédés solution-gélification.

L'avantage de l'utilisation de matériaux inorganiques déposés par procédé solution-gélification est qu'ils permettent d'obtenir une distance de fuite supérieure à la distance de dégagement de manière à être conforme à la norme IEC-60664.

Le deuxième moyen isolant recouvre donc au moins en partie la base de la paroi d'échange thermique. Pour avoir cette forme de plaque, le deuxième moyen isolant doit présenter une certaine rigidité et doit donc être plus rigide que le premier moyen isolant. À titre d'exemple, la rigidité du deuxième moyen isolant est comprise entre 10 Mpa et 1 GPa environ s'il s'agit d'un polymère organique, et supérieur à 1Gpa s'il s'agit d'une matière inorganique déposée par procédé solution-gélification.

Selon une caractéristique optionnelle de l'invention, le premier moyen isolant est en contact avec **l'excroissance** de la paroi d'échange thermique.

On comprend ainsi que le premier moyen isolant est disposé entre le module électronique et la base de la paroi d'échange thermique, tout en étant en contact avec l'excroissance de cette paroi, ce qui permet d'isoler totalement ladite excroissance.

Alternativement, le premier moyen isolant pourrait ne pas être en contact avec l'excroissance. En effet, le premier moyen isolant permet d'allonger la distance de fuite tant qu'il forme une continuité d'isolation en étant comprimé entre le module électronique et la base de la paroi d'échange thermique.

Selon une caractéristique optionnelle de l'invention, le premier moyen isolant est en contact avec l'excroissance de la paroi d'échange thermique de manière à assurer l'étanchéité à l'eau de la matière d'interface thermique du module électronique. Ceci permet notamment d'éviter des interférences dues à la présence d'eau au niveau de la matière d'interface thermique.

Selon une caractéristique optionnelle de l'invention, le deuxième moyen isolant est en contact avec l'excroissance de la paroi d'échange thermique. Dans ce cas, le premier moyen isolant est comprimé indirectement entre le module électronique et la base par l'intermédiaire du deuxième moyen isolant. Au contraire, lorsque le deuxième moyen isolant n'est pas en contact avec l'excroissance, le premier moyen isolant peut-être comprimé directement entre le module électronique et la base de la paroi d'échange thermique.

Selon une caractéristique optionnelle de l'invention, le deuxième moyen isolant s'étend de part et d'autre de l'excroissance de la paroi d'échange thermique.

Le deuxième moyen isolant peut ainsi consister en deux plaques ou plus se plaçant de part et d'autre de l'excroissance. Plus particulièrement, dans le cas où il y a deux plaques ou plus, celles-ci se placent sur les côtés de l'excroissance où les distances de fuite et de dégagement doivent être allongées.

Le deuxième moyen isolant peut également consister en une seule plaque entourant totalement l'excroissance. Dans ce cas, le deuxième moyen isolant comprend un orifice permettant au moins le passage de l'excroissance. Lorsque cet orifice est complémentaire de la forme de l'excroissance, le deuxième moyen isolant est en contact avec l'excroissance et doit être assemblé dans le système électronique avant l'assemblage du module électronique sur l'excroissance. Lorsque l'orifice a des dimensions plus grandes que celles de l'excroissance, le deuxième moyen isolant n'est pas en contact avec l'excroissance.

Selon une caractéristique optionnelle de l'invention, le premier moyen isolant et le deuxième moyen isolant garantissent une distance de dégagement d'au moins 10 mm entre au moins une des broches connexion du module électronique et la paroi d'échange thermique.

De cette manière, la distance de dégagement est allongée pour correspondre aux normes régissant cette distance, telles que la norme ISO 60664. À titre d'exemple, pour un module de puissance de 800 V, la distance de dégagement doit être supérieure à 5.6 mm, ce qui est atteint grâce au moyen de gestion des distances de fuite et de dégagement selon l'invention.

Selon une caractéristique optionnelle de l'invention, le premier moyen isolant et le deuxième moyen isolant garantissent une distance de fuite d'au moins 10 mm entre une des broches de connexion du module électronique et la paroi d'échange thermique.

De cette manière, la distance de fuite est allongée pour correspondre aux normes régissant cette distance, telles que la norme ISO 60664. À titre d'exemple, pour un module de puissance de 1250 V, la distance de fuite doit être de 9 mm, ce qui est atteint grâce au moyen de gestion des distances de fuite et de dégagement selon l'invention.

D'autres caractéristiques, détails et avantages de l'invention ressortiront plus clairement à la lecture de la description qui suit d'une part, et d'exemples de réalisation donnés à titre indicatif et non limitatif en référence aux dessins annexés d'autre part, sur lesquels :
[Fig. 1] est une vue en perspective d'un système électronique selon un premier mode de réalisation de l'invention ;
[Fig. 2] est une vue rapprochée d'une coupe du système électronique du premier mode de réalisation dans un plan de coupe longitudinal et vertical ;
[Fig. 3] est une vue rapprochée d'une coupe du système électronique d'un deuxième mode de réalisation dans un plan de coupe longitudinal et vertical similaire à celui de la figure 2 ;
[Fig. 4] est une vue rapprochée d'une coupe du système électronique d'un troisième mode de réalisation dans un plan de coupe longitudinal et vertical similaire à celui de la figure 2 ; et
[Fig. 5] est une vue rapprochée d'une coupe du système électronique d'un quatrième mode de réalisation dans un plan de coupe longitudinal et vertical similaire à celui de la figure 2.

Les caractéristiques et les variantes de l'invention peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites ci-après de manière isolée des autres caractéristiques décrites, si cette sélection de caractéristiques est suffisante pour conférer un avantage technique et/ou pour différencier l'invention par rapport à l'état de la technique antérieure.

Sur les figures, les éléments communs à plusieurs figures conservent la même référence.

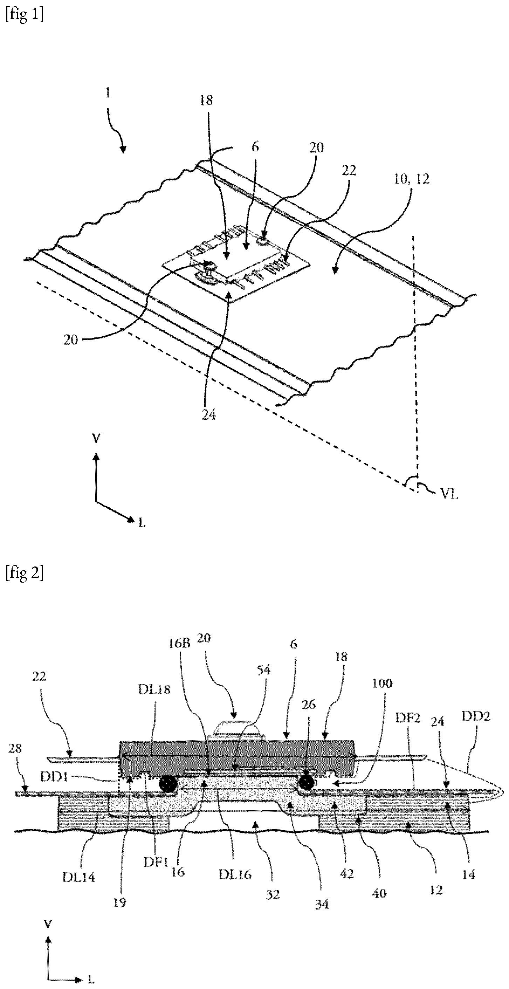

La figure 1 est une vue en perspective d'un système électronique 1 selon un premier mode de réalisation de l'invention.

Le système électronique 1, par exemple un dispositif de charge embarqué sur un véhicule électrique sans que cet exemple d'application soit limitatif de l'invention, comprend un carter, ici non visible, dimensionné pour recevoir une pluralité de composants électroniques parmi lesquels on peut trouver des bobines, des transistors ou encore, sans que cela soit limitatif, au moins une carte de circuits imprimés, et parmi lesquels on a notamment un ou plusieurs modules électroniques 6.

Le système électronique 1 est équipé d'un dispositif de refroidissement 10 par circulation de liquide de refroidissement, notamment destiné à la gestion thermique des modules de puissance, particulièrement aptes à s'échauffer lors de leur fonctionnement.

Le dispositif de refroidissement 10 comporte notamment une paroi d'échange thermique 12, ici visible sur la figure 1, qui participe à délimiter un conduit de circulation de fluide caloporteur, et qui présente une zone de fixation du module électronique 6. Cette zone de fixation consiste également en une zone d'échange thermique, puisque c'est au niveau de cette zone d'échange que des calories passent du module électronique au fluide caloporteur via la paroi d'échange thermique 12.

Le module électronique 6 comprend un boîtier de protection 18 fixé au dispositif de refroidissement 10. Des vis 20 sont destinées à coopérer avec des orifices formés sur le boîtier de protection 18 du module électronique 6 de sorte à maintenir ledit module électronique 6 fixé sur le dispositif de refroidissement 10.

Le boîtier de protection 18 est également connecté thermiquement au dispositif de refroidissement 10 par l'intermédiaire d'une matière d'interface thermique 16B également appelée interface thermique conductrice (TIM) pouvant être, à titre d'exemple, un gap filler, un gap pad, une feuille conductrice de carbone. Le dispositif de refroidissement 10 est ainsi au moins en partie fabriqué en un matériau thermiquement conducteur, qui est bien souvent également un matériau thermiquement conducteur, afin de pouvoir assurer un échange de chaleur entre le boîtier de protection 18 et ledit dispositif de refroidissement 10.

Le module électronique 6 comporte également au moins une broche 22, ici une pluralité de broches 22 qui servent à connecter ledit module électronique 6 à des éléments extérieurs au système électronique 1, par exemple une carte de circuit imprimé. Les broches 22 sont pour cela fabriquées en matériaux électriquement conducteurs.

Dans ce contexte, des interférences électriques sont possibles entre les broches 22 du module électronique 6 et le dispositif de refroidissement 10. En effet, à certains endroits, la distance de fuite et la distance de dégagement, qui correspondent respectivement à la distance la plus courte mesurée le long d'une surface électriquement isolante entre les broches 22 et le dispositif de refroidissement 10, et la distance la plus courte dans l'air entre les broches 22 et le dispositif de refroidissement 10, peuvent être trop courtes et entraîner ces interférences électriques.

Afin de contrer cette problématique, le système électronique 1 comprend un moyen de gestion 24 des distances de fuite et de dégagement.

Le ou les matériaux du moyen de gestion 24 sont choisis de manière à présenter un coefficient de résistance au courant de cheminement qui est au-delà d'un seuil donné pour présenter des performances d'isolation permettant un prolongement des distances de fuite et de dégagement. Des détails supplémentaires sur ce moyen de gestion 24 seront donnés dans la description des figures suivantes.

La figure 2 est une vue rapprochée d'une coupe du système électronique 1 selon le premier mode de réalisation dans un plan de coupe LV longitudinal et vertical. Ce plan de coupe LV, représenté sur la figure 1, s'étend parallèlement à un plan dans lequel s'étend majoritairement le boîtier de protection 18 du module électronique 6, et perpendiculairement à une direction s'étendant d'une vis 20 à l'autre.

La vue en coupe de la figure 2 rend particulièrement visible le dispositif de refroidissement 10, ainsi que sa paroi d'échange thermique 12 délimitant le conduit de circulation 32 de fluide caloporteur. La paroi d'échange thermique 12 est configurée de manière à présenter une base 14 et une excroissance 16, l'excroissance 16 étant la partie de la paroi d'échange thermique 12 par laquelle le module électronique 6 est connecté thermiquement à la paroi d'échange thermique 12. On comprend ainsi que l'excroissance 16 correspond ici à la zone d'échange thermique précédemment décrite, et donc à la zone de fixation du module électronique 6, sur la paroi d'échange thermique 12.

La paroi d'échange thermique 12 a de la sorte, dans la zone dans laquelle le module électronique la recouvre, une structure étagée dans une direction verticale V perpendiculaire à un plan dans lequel la base 14 de la paroi d'échange thermique 12 s'étend. La base 14 se situe à un premier étage, tandis que l'excroissance 16 se situe à un deuxième étage au contact du module électronique 6.

En d'autres termes, puisque le module électronique 6 est fixé à l'excroissance 16, on comprend que le module électronique 6 est disposé à distance de la base 14 dans la direction verticale V.

Dans ce mode de réalisation, une ouverture est formée dans la paroi d'échange thermique 12 et le dispositif de refroidissement 10 comporte un insert 34, configuré pour fermer l'ouverture. L'insert 34 participe ainsi à former la paroi d'échange thermique 12 en fermant l'ouverture. La présence de cet insert 34 permet, par exemple, de prévoir localement un matériau aux propriétés d'échange thermique plus élevées.

Il convient de noter que ce qui va être décrit en relation avec un insert 34 pourrait être appliqué à une paroi d'échange thermique 12 de configuration différente, sans insert 34, dès lors que le moyen de gestion 24 tel qu'il est décrit dans la présente demande est interposé entre les broches 22 et la paroi d'échange thermique 12.

Dans l'exemple illustré, puisque le dispositif de refroidissement 10 comprend un insert 34, la base 14 est ici en partie formée par l'insert 34, et c'est cet insert 34 qui comprend l'excroissance 16. Plus particulièrement, au niveau de l'ouverture, la paroi d'échange thermique 12 comprend un épaulement 40 permettant de disposer l'insert 34 en appui de sorte à obstruer le conduit de circulation 32 au niveau de la zone thermique d'échange formée entre le module électronique 6 et la paroi d'échange thermique 12. L'insert 34 comprend, lui, une partie de support 42, qui est la partie de ladite pièce en appui sur l'épaulement 40.

De cette manière, lorsque la partie de support 42 de l'insert 34 est positionnée sur l'épaulement 40, la face externe de la paroi d'échange thermique 12 est affleurante avec la face externe de la partie de support 42, de sorte que l'assemblage de l'insert 34 dans l'ouverture formée dans la paroi d'échange thermique 12 forme une surface continue correspondant à la base 14 de la paroi d'échange thermique 12.

Dans ce mode de réalisation, puisque l'insert 34 comprend l'excroissance 16 et la partie de support 42 destinée à former la base 14, on comprend que cet insert 34 comprend également une structure étagée, avec la partie de support 42 au premier étage et l'excroissance 16 au deuxième étage, ce qui donne finalement sa structure étagée à la paroi d'échange thermique 12.

Le boîtier de protection 18 du module électronique 6 est fabriqué en un matériau électriquement isolant. Comme précédemment décrit, le boîtier de protection 18 peut comporter, au niveau d'une face inférieure 19 en regard de la paroi d'échange thermique, une matière d'interface thermique 16B, qui permet de protéger les puces électroniques 54 logées au sein du boîtier tout en assurant une interface de transfert thermique avec la zone de transfert de la paroi d'échange thermique 12. Les puces électroniques sont connectées électriquement aux broches 22. Il convient de noter que chaque puce électronique 54 est l'élément du module électronique 6 qui émet de la chaleur, de sorte qu'il est souhaité, tel que visible sur la figure 2, que les puces électroniques soient au droit du passage de fluide caloporteur au sein du dispositif de refroidissement 10.

L'excroissance 16 est fabriquée en un matériau thermiquement conducteur. Elle est en contact de la face inférieure 19 du boîtier 18 du module électronique et, ici par l'intermédiaire de la matière d'interface thermique 16B, de la puce électronique 54 par une de ses surfaces, et en contact du fluide caloporteur du conduit de circulation 32 par une autre de ses surfaces. De cette façon, l'excroissance 16 permet un échange thermique entre la puce électronique 54 et le fluide circulant dans le conduit de circulation 32 par l'intermédiaire de la matière d'interface thermique 16B, ce qui permet d'évacuer les calories produites par le fonctionnement de ladite puce électronique 54 et ainsi de refroidir efficacement cette dernière.

Le boîtier de protection 18 du module électronique 6 a un dimensionnement longitudinal DL18, qui correspond à son dimensionnement dans une direction longitudinale L, cette direction étant parallèle au plan longitudinal L et perpendiculaire à la direction verticale V. De son côté, l'excroissance 16 a un dimensionnement longitudinal DL16, correspondant à son dimensionnement dans la direction longitudinale L. Ici, le dimensionnement longitudinal DL18 du boîtier de protection 18 est plus grand que le dimensionnement longitudinal DL16 de l'excroissance 16. Il convient de noter que la base 14 a également un dimensionnement longitudinal DL14, supérieur au dimensionnement longitudinal DL16 de l'excroissance 16.

Du fait de ces dimensionnements longitudinaux DL18, DL16 et DL14 et du positionnement du module électronique 6 à distance de la base 14 dans la direction verticale V, un espacement vide 100 est formé entre le module électronique 6 et la base 14 de la paroi d'échange thermique 12.

Dans ce contexte, si le moyen de gestion 24 des distances de fuite et de dégagement n'était pas présent, la distance de fuite entre les broches 22 et l'excroissance 16 correspondrait à la distance la plus courte entre ces deux éléments en longeant une surface isolante du boîtier de protection 18 du module électronique 6. La distance de dégagement serait, elle, la distance entre les broches 22 et la base 14 de la paroi d'échange thermique 12 en passant par l'air. Ces distances, notées respectivement DF1 pour la distance de fuite sans moyen de gestion 24 et DD1 pour la distance de dégagement sans moyen de gestion 24, sont représentées sur la figure 2 à des fins de compréhension, bien que cette figure montre un système électronique 1 comprenant le moyen de gestion 24, ce qui rallonge ces distances de fuite et de dégagement DF1 et DD1.

Le moyen de gestion 24 des distances de fuite et de dégagement comprend un ensemble d'isolation composé de deux moyens isolants : un premier moyen isolant 26 et un deuxième moyen isolant 28.

Le premier moyen isolant 26 et le deuxième moyen isolant 28 sont positionnés entre la base 14 de la paroi d'échange thermique 12 et le module électronique 6. Plus particulièrement, dans ce mode de réalisation, le premier moyen isolant 26 est interposé entre la face inférieure 19 du module électronique 6 et le deuxième moyen isolant 28, tandis que le deuxième moyen isolant 28 est interposé entre le premier moyen isolant 26 et la base 14 de la paroi d'échange thermique 12. On comprend donc que le premier moyen isolant 26 et le deuxième moyen isolant 28 sont disposés au niveau de **l'espacement** vide 100 précédemment défini.

Le premier moyen isolant 26 et le deuxième moyen isolant 28 ont une rigidité différente. Plus particulièrement, le premier moyen isolant 26 a ici une rigidité plus faible que la rigidité du deuxième moyen isolant 28. En effet, le premier moyen isolant 26 a dans ce mode de réalisation une forme de boudin et est comprimé entre le module électronique 6 et la base 14 de la paroi d'échange thermique 12 par l'intermédiaire du deuxième moyen isolant 28 ; il doit ainsi présenter une rigidité assez faible pour être comprimé. À titre d'exemple, le premier moyen isolant 26 peut avoir une rigidité comprise entre 1 et 10 MPa environ.

Le deuxième moyen isolant 28 est une plaque d'une épaisseur constante, s'étendant perpendiculairement à la direction verticale, ici le long de la base 14 de manière à la recouvrir. Le deuxième isolant 28 a pour vocation de ne pas se déformer à l'usage, et de conserver une forme sensiblement plane. À titre d'exemple, le deuxième moyen isolant 28 peut avoir une rigidité comprise entre 100 Mpa et 1 GPa environ lorsque la matière est un polymère, ou avoir une rigidité supérieure à 1GPa lorsqu'il s'agit de matière inorganique déposée par procédé solution-gélification.

Le premier moyen isolant 26 et le deuxième moyen isolant 28 sont fabriqués en matériaux électriquement isolants, tels que le polysiloxane ou le polyépoxyde. On entend par matériau électriquement isolant que les matériaux du premier et du deuxième moyen présentent un coefficient de résistance au courant de cheminement au-delà d'un seuil donné qui permet un prolongement des distances de fuite et de dégagement.

Dans ce mode de réalisation, le premier moyen isolant 26 est, en plus d'être comprimé entre le module électronique 6 et la base 14, en contact avec l'excroissance 16. En outre, le deuxième moyen isolant 28 est également en contact avec l'excroissance 16. On comprend ainsi que le premier moyen isolant 26 et le deuxième moyen isolant 28 entourent l'excroissance 16, de sorte qu'elle soit isolée du reste de l'espacement vide 100 précédemment défini.

Dans ce mode de réalisation, le deuxième moyen isolant 28 est ainsi une plaque comprenant un orifice destiné à entourer l'excroissance 16. L'orifice a donc une forme complémentaire à celle de l'excroissance 16, de sorte que le deuxième moyen isolant 28, au niveau de cet orifice, est en contact avec l'excroissance 16. On comprend qu'ainsi le deuxième moyen isolant 28 est disposé de part et d'autre de l'excroissance 16.

À titre d'alternative, le deuxième moyen isolant 28 peut également être composé de plusieurs parties détachables entre elles, permettant au deuxième moyen isolant 28 d'être disposé autour de l'excroissance 16 lorsqu'elles sont assemblées.

Il convient de noter que le moyen de gestion 24 peut être fixé au reste du système électronique 1. Plus particulièrement, le deuxième moyen isolant 28 peut, par exemple, être collé à la base 14 de la paroi d'échange thermique 12 et à l'excroissance 16.

Grâce à ce a moyen de gestion 24, formé conjointement par le premier moyen isolant 26 et le deuxième moyen isolant 28, les distances de fuite et de dégagement sont déviées et rallongées. La distance de fuite, notée DF2, est alors formée par un chemin longeant, à partir de la broche 22, une surface du boîtier 18, et notamment la face inférieure 19 du boîtier 18 participant à délimiter l'espacement vide 100, puis longeant une surface du premier moyen isolant 26, à savoir la forme bombée du premier moyen isolant 26 qui reste dégagée, c'est-à-dire au contact ni du boîtier 18, ni de l'excroissance 16, ni de la partie de support 42 destinée à former la base 14. Cette distance de fuite DF2 longe ensuite une surface du deuxième moyen isolant 28, en direction d'un bord d'extrémité libre à **l'opposé** de l'excroissance 16, celle-ci étant recouverte par le premier moyen isolant 26, avant d'atteindre la paroi d'échange thermique 12 en contournant ce bord d'extrémité libre. La distance de dégagement, notée DD2, est elle formée par un chemin passant dans l'air entre la broche 22 et la paroi d'échange thermique 12, ce chemin étant rallongé pour contourner le deuxième moyen isolant 28 et son bord d'extrémité libre. On comprend que cette distance de dégagement DD2, de même que la distance de fuite DF2, est d'autant plus rallongé si le deuxième moyen isolant 28 présente un bord d'extrémité libre qui s'étend au-delà de la base 14 de la paroi d'échange thermique 12.

On constate ainsi que le moyen de gestion 24, grâce à son premier moyen isolant 26 et son deuxième moyen isolant 28, rallonge considérablement les distances de fuite et de dégagement entre les composants électriques pouvant interférer au sein du système électronique 1, de manière à respecter les normes définissant ces distances.

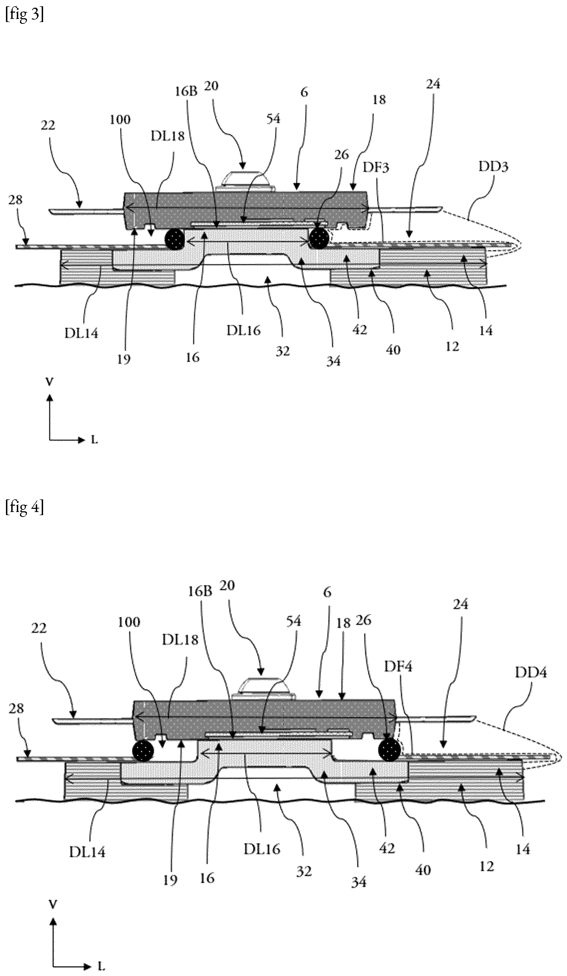

La figure 3 est une vue rapprochée d'une coupe d'un système électronique 1 selon un deuxième mode de réalisation dans un plan de coupe LV longitudinal et vertical.

Le système électronique de ce deuxième mode de réalisation diffère de ce qui vient d'être précédemment décrit en ce que le premier moyen isolant 26 n'est pas interposé entre le deuxième moyen isolant 28 et le module électronique 6.

En effet, ici, le premier moyen isolant 26 est comprimé directement entre le module électronique 6, et notamment la face inférieure 19 du boîtier 18 de ce module électronique, et la base 14 de la paroi d'échange thermique 12. Le premier moyen isolant 26 est également en contact avec l'excroissance 16. On comprend ainsi que le premier moyen isolant 26 est en contact direct avec le module électronique 6, la base 14 et l'excroissance 16.

Le deuxième moyen isolant 28, quant à lui, est disposé de manière à entourer le premier moyen isolant 26. Plus particulièrement, le deuxième moyen isolant 28 est en contact avec le premier moyen isolant 26 de manière à ce que, lorsqu'un courant électrique longe le premier moyen isolant 26, il court ensuite le long du deuxième moyen isolant 28 sans avoir l'opportunité d'atteindre la base 14 de la paroi d'échange thermique 12. Les distances de fuite et de dégagement correspondant à ce mode de réalisation sont représentées sur la figure 3 par les références DF3 et DD3.

La figure 4 est une vue rapprochée d'une coupe d'un système électronique 1 selon un troisième mode de réalisation dans un plan de coupe LV longitudinal et vertical.

Dans ce troisième mode de réalisation, et conformément à ce qui a été décrit pour le deuxième mode de réalisation, le deuxième moyen isolant 28 n'est pas interposé entre le premier moyen isolant 26 et la base 14, de sorte que le premier moyen isolant 26 est comprimé directement entre le module électronique 6 et la base 14 de la paroi d'échange thermique 12. Le système électronique selon le troisième mode de réalisation diffère de ce qui précède en ce que le premier moyen isolant 26 n'est pas en contact avec l'excroissance 16 et est disposé à distance de celle-ci. Le deuxième moyen isolant 28 est disposé autour du premier moyen isolant 26 et est en contact avec celui-ci, de manière similaire au deuxième mode de réalisation.

On comprend ainsi que, dans cette configuration, le courant électrique ne peut pas passer à l'intérieur de l'espacement vide 100 précédemment défini, puisqu'il est bloqué par le premier moyen isolant 26, dès lors que ce premier moyen isolant 26 est bien comprimé entre la face inférieure 19 du boîtier 18 du module électronique 6 et la base 14, et le deuxième moyen isolant 28. Les distances de fuite et de dégagement correspondant à ce troisième mode de réalisation sont représentées sur la figure 4 par les références DF4 et DD4, et sont rallongés et déviés conformément à ce qui précède, de sorte que les courants électriques doivent contourner l'extrémité libre du deuxième moyen isolant 28 pour rejoindre la paroi d'échange thermique 12.

Dans chacun des trois premiers modes de réalisation illustrés et décrits, le premier moyen isolant 26 et le deuxième moyen isolant 28 peuvent former un ensemble d'un seul tenant, apte à être monté en une seule opération lors de l'assemblage du système électronique. Dans ce contexte, le premier moyen isolant 26 peut être collé au deuxième moyen isolant 28 pour que l'ensemble ainsi formé puisse être manipulé aisément et positionné autour de l'excroissance à la position souhaitée selon le mode de réalisation mis en œuvre. Outre la simplification du procédé qui en résulte, on peut noter que cela permet de s'assurer que l'étanchéité entre les moyens isolants est assurée, évitant le passage de courant électrique entre eux une fois assemblés.

De manière alternative, on peut envisager que les moyens isolants soient disposés l'un après l'autre dans la position souhaitée, et que c'est la fixation du module électronique 6 sur l'excroissance 16, tendant à comprimer le premier moyen isolant 26 et à l'étaler, qui assure la bonne connexion entre les deux moyens isolants et leur coopération au sens de l'invention pour dévier et rallonger les distances de fuite et de dégagement.

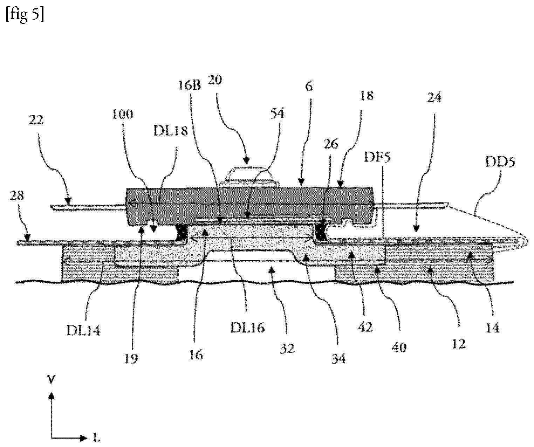

La figure 5 est une vue rapprochée d'une coupe d'un système électronique 1 selon un quatrième mode de réalisation dans un plan de coupe LV longitudinal et vertical.

Dans ce quatrième mode de réalisation, le premier moyen isolant 26 et le deuxième moyen isolant 28 sont disposés de manière similaire au premier mode de réalisation, avec le premier moyen isolant 26 interposé, le long de l'excroissance 16, entre le module électronique 6 et le deuxième moyen isolant 28.

Le système électronique selon ce quatrième mode de réalisation diffère de ce qui a été précédemment décrit en ce que le premier moyen isolant 26 est ici une colle qui a été disposée comme un joint autour de l'excroissance 16 de manière à être en contact avec l'excroissance 16, le module électronique 6 et le deuxième moyen d'isolation 28. Les distances de fuite et de dégagement correspondant à ce quatrième mode de réalisation sont représentées sur la figure 5 par les références DF5 et DD5 et peuvent être considérées comme les distances de fuite et de dégagement DF2 et DD2 du premier mode de réalisation.

Dans ce mode de réalisation, par opposition aux modes de réalisation précédents, le premier moyen isolant 26 est formé une fois que le deuxième moyen isolant 28 et le module électronique 6 sont déjà positionnés. On s'assure de la sorte que la colle est bien injectée dans le fond de l'espacement vide 100, contre l'excroissance 16, et remplisse bien l'espacement 100.

Telle qu'elle vient d'être décrite, la présente invention atteint bien le but qu'elle s'était fixé, en proposant un système électronique comprenant notamment un module électronique, un dispositif de refroidissement et un moyen de gestion des distances de fuites muni d'un premier moyen isolant et d'un deuxième moyen isolant coopérant afin de rallonger les distances de fuite et de dégagement entre ce module électronique et le dispositif de refroidissement. Grace à ces caractéristiques, il est ainsi possible d'utiliser un module électronique dans le système électronique, sans risquer d'avoir des problèmes d'interférences électrique/électronique entre ledit module et le dispositif de refroidissement.

La présente invention ne saurait toutefois se limiter aux moyens et configurations décrits et illustrés ici et elle s'étend également à tout moyen et toute configuration équivalente ainsi qu'à toute combinaison techniquement opérante de tels moyens.

## Revendications

1. Système électronique (1) comprenant un carter ainsi qu'un module électronique (6) et un dispositif de refroidissement (10) dudit module électronique (6) qui sont logés dans ledit carter, le module électronique (6) comportant des puces électroniques (54) logées dans un boîtier de protection (18) et des broches de connexion (22) raccordées auxdites puces (54) et traversant le boîtier de protection (18), le dispositif de refroidissement (10) comprenant un conduit de circulation (32) de fluide délimité au moins par une paroi d'échange thermique (12) contre laquelle est rapporté le module électronique (6), la paroi d'échange thermique (12) étant dotée d'une base (14) et d'une excroissance (16) connectée thermiquement au module électronique (6) via une matière d'interface thermique (16B) et permettant de positionner le module électronique (6) à distance de la base (14) dans une direction verticale (V), le système électronique (1) étant muni d'un moyen de gestion (24) des distances de fuites et de dégagement entre au moins une broche de connexion (22) du module électronique (6) et la paroi d'échange thermique (12), **caractérisé en ce que** le moyen de gestion (24) comprend un ensemble d'isolation composé d'au moins deux moyens isolants de rigidité différente parmi lesquels un premier moyen isolant (26) est comprimé entre la base (14) de la paroi d'échange thermique (12) et le module électronique (6), et un deuxième moyen isolant (28) s'étend perpendiculairement à la direction verticale (V).

2. Système électronique (1) selon la revendication 1, dans lequel le deuxième moyen isolant (28) est en contact avec le premier moyen isolant (26) et avec la base (14) de la paroi d'échange thermique (12).

3. Système électronique (1) selon la revendication 2, dans lequel le premier moyen isolant (26) est interposé entre le deuxième moyen isolant (28) et le module électronique (6).

4. Système électronique (1) selon l'une quelconque des revendications 2 ou 3, dans lequel le premier moyen isolant (26) et le deuxième moyen isolant (28) sont fixés l'un à l'autre.

5. Système électronique (1) selon l'une quelconque des revendications 1 à 4, dans lequel le deuxième moyen isolant (28) est une plaque, une feuille ou un film.

6. Système électronique (1) selon l'une quelconque des revendications 1 à 4, dans lequel le deuxième moyen isolant (28) est une ou plusieurs couches de polymères organiques déposées en tant que peinture isolante.

7. Système électronique (1) selon l'une quelconque des revendications 1 à 4, dans lequel le deuxième moyen isolant (28) est une ou plusieurs couches de matière isolante inorganique déposée par des procédés solution-gélification.

8. Système électronique (1) selon l'une quelconque des revendications 1 à 7, dans lequel le premier moyen isolant (26) est en contact avec l'excroissance (16) de la paroi d'échange thermique (12).

9. Système électronique (1) selon l'une quelconque des revendications 1 à 8, dans lequel le premier moyen isolant (26) est en contact avec l'excroissance (16) de la paroi d'échange thermique (12) de manière à assurer l'étanchéité à l'eau de la matière d'interface thermique (16b) du module électronique (6).

10. Système électronique (1) selon l'une quelconque des revendications 1 à 9, dans lequel le deuxième moyen isolant (28) est en contact avec l'excroissance (16) de la paroi d'échange thermique (12).

11. Système électronique (1) selon l'une quelconque des revendications 1 à 10, dans lequel le deuxième moyen isolant (28) s'étend de part et d'autre de l'excroissance (16) de la paroi d'échange thermique (12).

12. Système électronique (1) selon l'une quelconque des revendications 1 à 11, dans lequel le premier moyen isolant (26) et le deuxième moyen isolant (28) garantissent une distance de dégagement d'au moins 10 mm entre au moins une des broches de connexion (22) du module électronique (6) et la paroi d'échange thermique (12).

13. Système électronique (1) selon l'une quelconque des revendications 1 à 12, dans lequel le premier moyen isolant (26) et le deuxième moyen isolant (28) garantissent une distance de fuite d'au moins 10 mm entre une des broches de connexion (22) du module électronique (6) et la paroi d'échange thermique (12).
